# FASCICULE DE BREVET EUROPEEN

(11) **EP 2 963 695 B1**
(45) Date de publication et mention de la délivrance du brevet: **18.10.2023**
(21) Numéro de dépôt: 15171014.2
(22) Date de dépôt: 08.06.2015
(51) Int. Cl.: H10N 97/00, H01G 4/005, H01L 23/64, C25D 5/02, H01G 4/30

(54) **DISPOSITIF ÉLECTRIQUE MULTICOUCHES**
ELEKTRISCHE MEHRSCHICHTENVORRICHTUNG
MULTI-LAYER ELECTRIC DEVICE

(30) Priorité: 10.06.2014 FR 1455212
(43) Date de publication de la demande: 06.01.2016
(73) Titulaire: COMMISSARIAT À L'ÉNERGIE ATOMIQUE ET AUX ÉNERGIES ALTERNATIVES, 75015 Paris (FR)
(72) Inventeur: PELLOQUIN, Sylvain, 38000 Grenoble (FR); DIEPPEDALE, Christel, 38920 Crolles (FR); LE RHUN, Gwenaël, 38140 Renage (FR); SIBUET, Henri, 38500 La Buisse (FR)
(74) Mandataire: Hautier IP

(56) Documents cités:
- US-A- 4 510 810
- US-A1- 2004 152 258
- US-A1- 2007 105 257

## Description

### DOMAINE TECHNIQUE DE L'INVENTION

La présente invention concerne en général la formation de dispositifs électriques multicouches alternant couches isolantes et conductrices et plus particulièrement mais non limitativement la réalisation de capacités multicouches ou de structures de routage denses. Une application possible s'adresse à des dispositifs à base de matériaux semi-conducteurs.

Elle permet par exemple de réaliser un dispositif électrostatique par empilement alterné de couches conductrices et diélectriques que l'on vient avantageusement connecter avec un nombre réduit de masques litho graphiques. Ce type de dispositif est particulièrement adapté pour être réalisé en technologie microélectronique ce qui inclut les nanotechnologies. L'invention permet d'accéder à une forte densité surfacique d'accumulation électrique avec une technologie de fabrication à coût réduit.

L'invention peut également être utilisée pour procéder à des redistributions de lignes électriques en utilisant la propriété de superposition de ces lignes pour bénéficier d'un gain de surface et donc d'une diminution de coût.

### ÉTAT DE LA TECHNIQUE

L'industrie de la microélectronique utilise couramment des structures stratifiées de type métal/isolant/métal (MIM) où l'on empile des couches, alternativement isolantes et conductrices sur le plan électrique, notamment pour former des capacités de forte valeur à des coûts raisonnables en raison de l'économie de surface que la superposition de ces couches permet.

Des structures de ce type ont déjà été décrites notamment celles décrites dans le document US 5,745,335. Cette publication relate un procédé de fabrication d'un système capacitif au-dessus d'un substrat. La fabrication commence par le dépôt alterné pleine plaque d'une pluralité d'empilements comprenant chacun une couche électriquement conductrices et une couche électriquement isolante. Cette pluralité de couches déposées est alors gravée de sorte à définir, par chaque empilement, un motif d'électrode. Il s'ensuit la création de plusieurs niveaux d'électrodes au-dessus de la face du substrat sur laquelle les dépôts ont été effectués. Dans cette superposition, les motifs d'électrodes sont différents de sorte à autoriser une reprise de contact, pour la connexion de la couche conductrice de chaque empilement, à un élément extérieur. Plus précisément, on commence par graver l'empilement de plus haut niveau, en lui donnant une forme et, donc un contour et une superficie déterminée. Ensuite, on opère des gravures successives pour les empilements des niveaux inférieurs. Cette fabrication dans laquelle on forme progressivement les électrodes en descendant pas à pas vers la surface du substrat, est aussi dénommée « top down » (soit, de haut en bas) dans la littérature. On configure ces gravures de sorte que, entre deux niveaux successifs, l'empilement supérieur soit de superficie strictement plus petite que celle de l'empilement inférieur et de sorte que l'empilement supérieur ait un contour contenu dans le périmètre de l'empilement inférieur. La structure empilée est de section croissante vers le substrat au-dessus duquel elle se trouve et s'apparente à une structure du type « mesa structure ».

Ainsi, pour chaque empilement, on ménage une partie latérale non recouverte de sa couche conductrice, ce qui permet un accès pour la reprise de contact. La réalisation proposée par US 5,745,335 offre ainsi une possibilité de reprises de contact latérale des couches pour former les électrodes de capacité. Les reprises de contact sont produites par des éléments de contact traversant une couche diélectrique recouvrant la structure empilée et dotés, chacun, d'une extrémité de raccordement électrique appliquée sur une couche conductrice d'un empilement (au niveau d'un bord de la couche conductrice non recouvert par les couches qui la surmontent) et d'une extrémité de raccordement extérieur.

Ce type de structure d'empilements a des intérêts en termes de fabrication et de formation des reprises de contact. Cependant, les gravures successives, au niveau des flancs de chaque empilement composé d'une couche conductrice et d'une couche isolante, peut créer des zones électriquement défectueuses sur les flancs de gravure. Ces zones défectueuses entrainent une diminution des performances et une perte de fiabilité du dispositif due notamment aux problèmes de reproductibilité industrielle de cette méthode de fabrication.

Une autre structure capacitive de type « mesa », comprenant plusieurs empilements sur une première couche électriquement conductrice, chaque couche électriquement conductrice comprenant une zone exposée en périphérie, est divulguée dans le document US 2007/105257 A1.

On connait par ailleurs du document US-A1-2004/152258 une structure capacitive comprenant en empilement une pluralité d'électrodes, sur la base d'un substrat semiconducteur. Cette publication propose une méthode différente de raccordement électrique des électrodes, au moyen de trous réalisés dans les électrodes elles-mêmes. Plus précisément, une électrode donnée, recouverte par une électrode qui la surmonte, est raccordée par un élément de reprise de contact traversant un trou formé dans l'électrode qui la surmonte. Les trous doivent être suffisamment larges pour ne pas risquer des contacts avec les organes de reprise de contact traversant et la précision de montage de ces contacts est une véritable contrainte. La surface active des électrodes, donc la capacité électrique finale, est impactée défavorablement.

C'est donc un objet de l'invention que de décrire un dispositif et un procédé de réalisation qui permettent de répondre à ce problème, avantageusement en utilisant des moyens traditionnels mis en oeuvre par l'industrie de la microélectronique.

D'autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Un premier aspect de l'invention est défini par la revendication 1.

Grâce à l'invention, une zone périphérique dans chaque couche conductrice dans les empilements est isolée de sorte qu'elle n'est plus active. Or cette zone périphérique est le lieu de défauts potentiels, notamment lors de gravures permettant, dans les couches déposées, de définir les bords des motifs à former (par exemple pour définir le contour d'électrodes de capacités). En particulier, dans l'hypothèse où une gravure de flanc entrainerait une re-déposition de matériau conducteur sur les flancs d'une couche isolante, ce qui occasionnerait des défauts d'isolement électrique, le motif électriquement isolant permet de rétablir l'isolation entre les différentes couches et évite l'effet de pointe en bout d'électrode dans le cas de capacités.

Ce motif supplémentaire, formant un anneau de garde autour de chaque couche conductrice dans les empilements, peut être réalisé indépendamment ou être réalisé simultanément avec la gravure de la première couche conductrice.

Le dispositif comporte, pour chaque couche électriquement conductrice comprenant un motif électriquement isolant, un élément de reprise de contact en continuité électrique avec une zone de connexion située dans la portion exposée de ladite couche électriquement conductrice, hors de la zone électriquement isolée.

Grâce à cette configuration, la reprise de contact est réalisée de manière indépendante des motifs isolants et dans la zone exposée. Cela facilite la fabrication des reprises de contact. D'une part, il n'y a pas de risque de court-circuit entre les éléments de reprise de contact et la partie active des couches conductrices car ces éléments passent sur le côté de ces couches, et non au travers, et au surplus en bordant seulement les zones isolées des couches. On peut donc se permettre des tolérances de précision dans la résolution de fabrication des éléments de reprise de contact, tout en étant sûr qu'ils n'interféreront pas avec les parties électriquement actives des couches. La densité d'intégration peut d'autre part être plus grande car la proportion de surface active des couches superposées est élevée.

Un autre aspect de l'invention est défini par la revendication 5.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
- La FIGURE 1 illustre une étape de formation d'une pluralité de couches dans le cadre de réalisation de l'invention ;
- La FIGURE 2 montre une étape de lithographie et de gravure en vue de la formation d'un empilement ;
- La FIGURE 3 et 4 montrent des étapes successives similaires à celle de la Figure 2 ;
- La FIGURE 5 présente une lithographie et une gravure d'une couche électriquement conductrice de base, formant une première couche à la surface du substrat ;
- La FIGURE 6 illustre la création de tranchées dans les couches électriquement conductrices ;
- La FIGURE 7 présente, en vue de dessus, le résultat obtenu après l'étape de la figure 6 et retrait du masque de la figure 6 ;
- La FIGURE 8 représente la formation d'une couche isolante supérieure et d'ouvertures dans cette couche ;
- La FIGURE 9 montre, suite à la figure 8, la création des éléments de reprise de contact au travers des ouvertures ;
- La FIGURE 10 est une vue de dessus correspondant à la vue en coupe de la figure 9.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs relatives des différentes couches ne sont pas forcément représentatives de la réalité.

### DESCRIPTION DÉTAILLÉE DE L'INVENTION

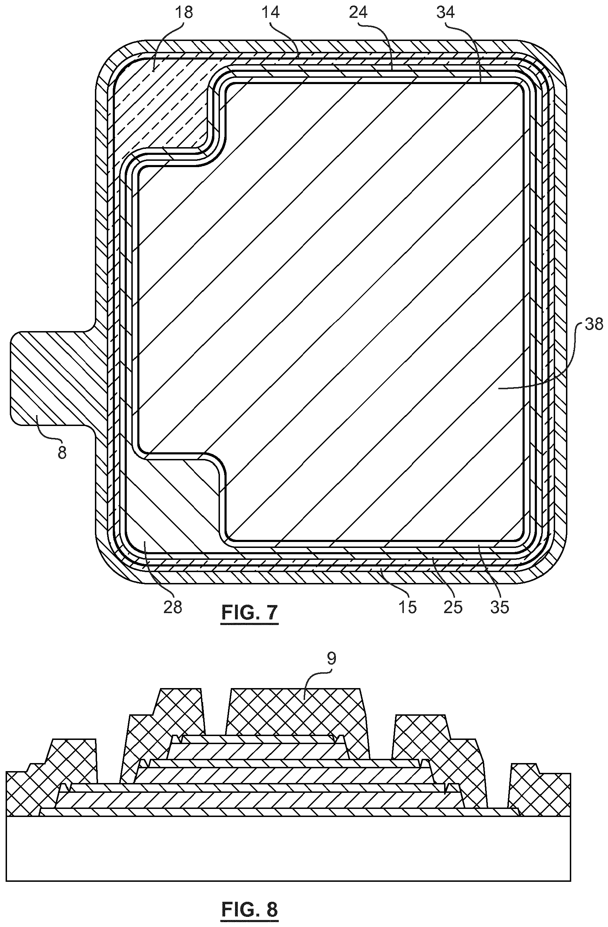

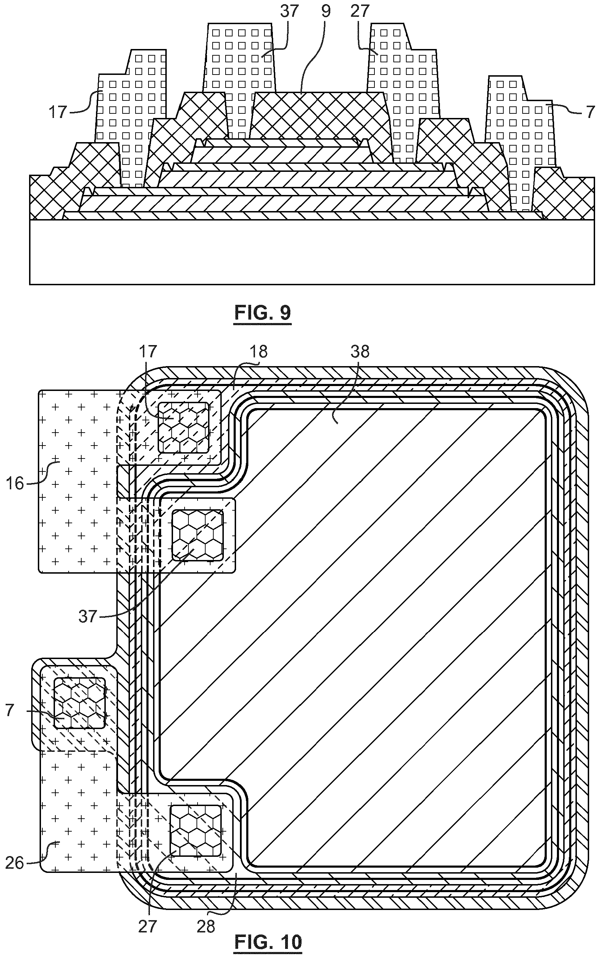

Avant d'entamer une revue détaillée de modes de réalisation de l'invention, sont énoncées ci-après des caractéristiques purement optionnelles qui peuvent éventuellement être utilisées en association selon toutes combinaisons entre elles ou alternativement :
- le dispositif comprend une couche électriquement isolante 9 recouvrant l'intégralité des couches électriquement conductrices 2, 12, 22, 32 et traversée par les éléments de reprise de contact 17, 27, 37.
- le contour de ladite couche électriquement conductrice comprend une portion parallèle au contour de la couche électriquement conductrice immédiatement inférieure et une portion en retrait relativement au contour de la couche électriquement conductrice immédiatement inférieure ; ainsi, les contours de deux couches conductrices se suivant ont en partie un même profil, avec des formes homothétiques de dimension réduite au fur et à mesure que les empilements sont superposés ; cette partie de même contour peut représenter une majorité du périmètre des couches conductrices ; une autre partie n'est pas de même contour, à savoir que la couche conductrice du dessus présente une partie en retrait (par exemple en formant une section concave du profil du contour de la couche concernée) relativement au contour de la couche du dessous ; cette partie en retrait forme une portion où la zone exposée de la couche électriquement conductrice inférieure est plus grande que sur le reste du contour de la couche ; cette portion peut être le lieu d'une reprise de contact, par l'extérieur des couches conductrices et ne limitant que peu les surfaces actives des couches conductrices.
- la zone de connexion de la couche immédiatement inférieure est réalisée de sorte à être située au niveau de la portion en retrait ; cela permet de limiter à une seule portion (celle avec la zone en retrait dont un exemple est visible en vue de dessus en figure 7), la surface de la zone exposée (hors de la zone isolée) de la couche à raccorder qui doit être suffisamment grande pour recevoir le contact de l'élément de reprise de contact. Le reste des couches conductrices est donc largement en vis-à-vis de sorte à ne pas pénaliser les surfaces actives de l'empilement. L'implantation des éléments de reprise de contact au niveau des zones en retrait est visible en figure 10.
- Le procédé peut être tel que
   la tranchée 14, 24, 34 est formée par masquage de définition d'un motif de tranchée suivi par une gravure d'une tranchée 14, 24, 34 en dehors du masque dans ladite couche électriquement conductrice.
- on forme, pour la couche électriquement conductrice 12, 22, 32 de chaque empilement 10, 20, 30, un motif électriquement isolant configuré pour définir une zone périphérique électriquement isolée 15, 25, 35 située dans la portion exposée 8, 18, 28, 38 de ladite couche électriquement conductrice 12, 22, 32.
- les tranchées 14, 24, 34 des couches électriquement conductrices 12, 22, 32 sont formées lors des mêmes étapes de masquage et de gravure.
- le procédé comporte la formation d'une couche électriquement isolante supérieure 9 recouvrant l'intégralité des couches électriquement conductrices 2, 12, 22, 32 et traversée par les éléments de reprise de contact 7, 17, 27, 37.
- la formation d'un élément de reprise de contact 7, 17, 27, 37 est opérée par une gravure de motifs d'éléments de reprise de contact au travers de la couche électriquement isolante supérieure 9, un dépôt d'une couche d'un matériau électriquement conducteur au-dessus de la couche électriquement isolante supérieure et dans lesdits motifs, puis une gravure de la couche d'un matériau électriquement conducteur de sorte à définir les éléments de reprise de contact 7, 17, 27, 37.
- la gravure de la couche d'un matériau électriquement conducteur est configurée pour isoler électriquement l'un de l'autre au moins deux éléments de reprise de contact.
- la formation de la première couche 2 électriquement conductrice et du au moins un empilement 10, 20, 30 comprend :
   - des dépôts pleine plaque successifs, à partir de la surface de substrat 1 d'une couche de formation de la première couche 2 électriquement conductrice et d'autant d'alternances de couches électriquement conductrices et de couches isolantes que d'empilements 10, 20, 30,
   - pour chaque empilement 10, 20, 30, en commençant par l'empilement 30 de plus haut niveau au-dessus de la surface du substrat 1, un masquage de définition d'un motif du dit empilement 10, 20, 30 et une gravure des couches de l'alternance correspondant au dit empilement 10, 20, 30 en dehors du masque, la dite gravure étant configurée pour préserver l'empilement 10, 20 immédiatement inférieur au dit empilement 20, 30 ou la couche de formation de la première couche 2 électriquement conductrice,
   - après la formation de tous les empilements 10, 20, 30, un masquage de définition d'un motif de la première couche 2 électriquement conductrice et une gravure de la couche de formation de la première couche électriquement conductrice en dehors du masquage 4,
- on opère le masquage de définition d'un motif de la première couche 2 électriquement conductrice et le masquage de définition des motifs de tranchée 14, 24, 34 lors d'une même étape, et la gravure de la couche de formation de la première couche électriquement conductrice et la gravure des tranchées 14, 24, 34 lors d'une même étape.

Il est précisé que dans le cadre de la présente invention, les termes « sur » ou « au-dessus » ne signifient pas obligatoirement « au contact de ». Ainsi par exemple, des couches intercalaires ou des organes intermédiaires peuvent être présents.

D'une façon générale, on entend par hauteur, une dimension située suivant l'épaisseur du substrat 1. Le substrat 1 comporte généralement deux faces opposées autour de son épaisseur, l'une des faces étant employée pour la réalisation de l'invention. Cette face est avantageusement plane, suivant un plan avantageusement perpendiculaire à l'épaisseur du substrat. Le substrat 1 peut être massif ou multicouches et en différents matériaux tels que des matériaux conducteurs, isolants ou semi-conducteurs, par exemple le silicium. Le substrat 1 peut lui-même comporter plusieurs couches. Par exemple, le substrat 1 peut comporter une couche superficielle diélectrique au-dessus de laquelle la succession de couches de l'invention est réalisée. Le substrat 1 peut aussi éventuellement incorporer des organes tels que des éléments électriques actifs ou passifs. Le substrat 1 est de manière générale la partie de support servant lors des étapes de fabrication du dispositif et dont au moins une partie est avantageusement conservée à l'issue de la fabrication pour participer audit dispositif. Il peut être constitué ou à base de silicium monocristallin et se présenter sous la forme de tranche mince généralement qualifiée du terme anglais de « wafer ».

On entend par électriquement conducteur un matériau de conductivité permettant de réaliser une fonction de conduction de l'électricité dans son application. Un matériau électriquement isolant s'entend d'un matériau dont la résistivité électrique lui permet, dans son application, de servir de barrière à la conduction d'électricité. Le terme diélectrique est ici employé dans le même sens.

Le terme motif s'entend de toutes configurations géométriques pour lesquelles une forme rentrante est opérée en creux dans l'épaisseur d'au moins une couche de matériau. Ce motif peut être fabriqué par un évidement, par gravure en particulier. Le motif peut aussi être rempli, par exemple avec un matériau électriquement isolant.

Des techniques connues de croissance, de dépôt et de gravure de ces matériaux et de tous ceux, conducteurs ou isolants, utilisés en microélectronique sont possiblement employées à partir de substrats le plus souvent. La définition des motifs se fait notamment par photolithographie à partir de masques, de résines photo-sensibles et par leur insolation mais aussi possiblement par d'autres moyens.

On pourra avoir recours typiquement à des gravures chimiques spécifique de chaque matériau par exemple par un plasma neutre ou également à une gravure de type plasma réactif laquelle est formée dans un réacteur de gravure où les dispositifs à graver sont exposés à celui-ci. Dans le cas de l'utilisation d'un plasma réactif pour réaliser les tranchées d'isolement 14, 24, 34 la couche isolante de chaque empilement peut servir d'arrêt de gravure à la couche conductrice dudit empilement.

On remarquera ici que les dépôts successifs des matériaux conducteurs et isolants sont de préférence adaptés pour être conformes c'est-à-dire qu'ils permettent d'obtenir des épaisseurs de dépôt sensiblement égales sur toute la couche considérée. Les couches formées peuvent être elles-mêmes constituées d'une ou de plusieurs sous couches.

Les matériaux conducteurs pouvant constituer les couches conductrices comprennent en particulier les métaux ou leurs alliages utilisés en microélectronique : l'aluminium (AI), l'or (Au), le cuivre (Cu), le platine (Pt) et possiblement toutes sortes de matériaux naturellement conducteurs ou rendus conducteurs, notamment par dopage comme les matériaux semi-conducteurs et en particulier le silicium dopé, ou les oxydes conducteurs. Le dépôt de ces matériaux peut se faire, en fonction du matériau, à l'aide de l'une ou l'autre des techniques communément utilisées par l'industrie de la microélectronique et qui sont le plus souvent désignées par les termes : PVD, CVD, PECVD et ALD, ECD, acronymes de l'anglais correspondant respectivement à « physical vapor déposition », « chemical vapor déposition », « Plasma-enhanced chemical vapor déposition », « atomic layer déposition », c'est-à-dire « déposition physique en phase vapeur », « déposition chimique en phase vapeur », « déposition chimique en phase vapeur assistée par plasma », « déposition de couches atomiques », « dépôt électrochimiques ». Le dépôt peut se faire aussi par « spin coating » c'est-à-dire par centrifugation du matériau déposé sous forme liquide ou visqueuse à la surface du substrat. Les épaisseurs déposées sont typiquement comprises dans une gamme de valeurs allant de 10 nm (nanomètre, c'est-à-dire 10.10-9 mètre) à 2 µm.

Les matériaux utilisables pour former tout ou partie des éléments diélectriques de l'invention sont par exemple le silicium (Si) et son oxyde (SiO2) ou nitrure (SiN) qui sont des isolants. D'autres exemples sont donnés ci-après : l'alumine (Al2O3), l'oxyde d'hafnium (HfO2), des céramiques comme le titano-zirconate de plomb (PZT) ou les titanates de baryum et de strontium (BST). Ils sont par exemple déposés avec les mêmes méthodes que celles mentionnées ci-dessus ou encore par PLD, acronyme de l'anglais «pulsed laser déposition », c'est-à-dire « dépôt par ablation laser pulsé ». Les épaisseurs déposées sont typiquement comprises dans une gamme de valeurs allant de 10 nm (nanomètre, c'est-à-dire 10.10-9 mètre) à 2 µm. A titre d'exemple additionnel, les couches isolantes peuvent être formées par dépôts ou traitements chimiques et notamment oxydation ou nitruration. Ainsi, les phases de dépôt peuvent par exemple être limitées à la création des couches conductrices, puis entre chaque dépôt une partie de leur épaisseur est traitée pour créer des couches isolantes.

Selon l'invention, on crée une succession de couches isolantes et de couches conductrices. On décrit plus loin en détail comment cette succession préserve dans au moins une couche conductrice une portion non recouverte par d'autres couches de la succession, notamment par des couches qui la surmontent, en particulier des couches conductrices supérieures. Cette portion non recouverte par d'autres couches est encore ici appelée portion exposée. Dans l'invention, la portion exposée parcourt l'intégralité du contour de la couche qui la comprend si bien qu'il s'agit, dans le cas décrit en référence aux figures, d'une portion périphérique de la couche, cette portion périphérique étant exposée, à savoir non recouverte par des empilements qui éventuellement la surmontent. Le terme « exposée » ne signifie pas forcément que la portion en question est, au final, non recouverte. Ce peut en particulier être le cas au moins partiellement avec une couche de couverture isolante. Le terme « exposée » s'entend uniquement donc de manière relative aux empilements de l'invention.

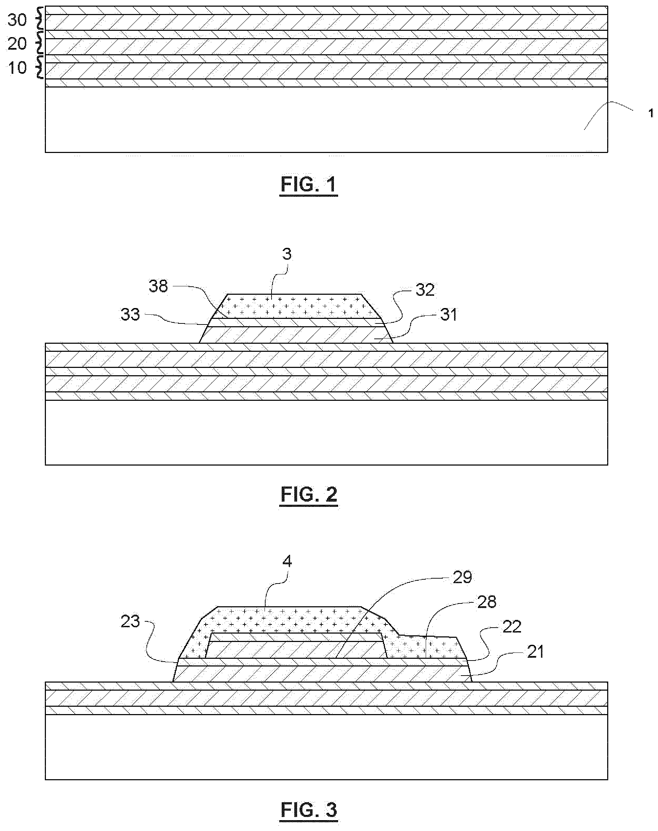

Les figures 1 à 5 montrent une première phase du procédé de l'invention, permettant de parvenir à une mesa structure à la surface du substrat 1.

En figure 1, on commence par opérer le dépôt d'une succession de couches à partir d'une face du substrat 1. Cette succession de couches est préférentiellement obtenue par une technique de dépôt pleine plaque, par exemple en suivant les technologies de dépôt décrites précédemment. La succession de couches comporte d'abord une première couche électriquement conductrice 2. Dans le cas de capacité, cette couche 2 est apte à former une électrode inférieure.

Au-dessus de la première couche 2, plusieurs empilements sont créés. Dans l'exemple des figures, on forme 3 empilements successivement 10, 20, 30 au-dessus de la première couche 2. Chaque empilement 10, 20, 30 comporte au moins une couche électriquement isolante 11, 21, 31 servant à isoler deux couches conductrices qui se suivent.

Tant pour les couches conductrices que pour les couches isolantes, des exemples de matériaux utilisables ont été donnés plus haut.

L'étape de la figure 2 révèle un mode de réalisation pour définir la configuration finale des empilements, en commençant par l'empilement de niveau supérieur repéré 30. Cette étape, par exemple, produit une électrode supérieure à partir de l'empilement 30 dans le cas d'une capacité. Un masque 3 est employé pour définir un motif de gravure, et plus particulièrement, pour définir une portion de surface de l'empilement 30 qui ne sera pas éliminé par la gravure.

On pourra recourir aux techniques conventionnelles de photolithographie. La gravure mise en oeuvre est configurée pour préserver (au moins partiellement) la couche électriquement conductrice 22 située sous l'empilement 30. On pourra notamment adapter la cinétique de gravure à cet effet.

Le résultat de la figure 2 est un empilement 30 supérieur dont le contour est défini par un flanc 33.

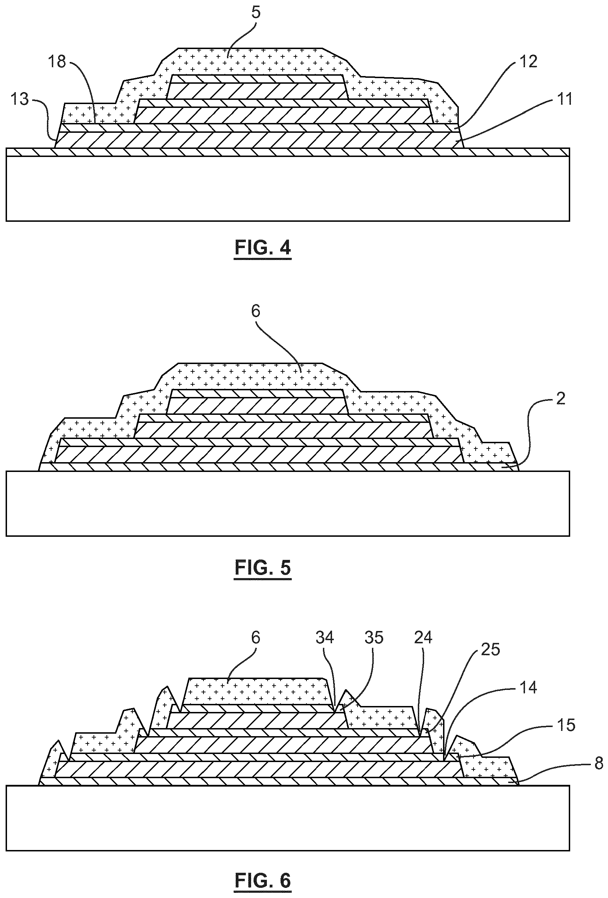

Les étapes suivantes des figures 3 et 4 sont relativement similaires à celle de la figure 2. Ainsi, en figure 3, on crée le contour du deuxième empilement 20 par une gravure en dehors d'une zone recouverte par un masque 4 dont la forme délimite le flanc 23 de l'empilement 20. De même, la figure 4 montre une création de l'empilement 10, ici empilement inférieur, au moyen d'une gravure en dehors d'une zone définie par un masque 5. La technique de définition des masques 3, 4, 5 peut être identique.

Comme pour le cas de la gravure de l'empilement 30, on s'arrange pour préserver la couche électriquement conductrice suivante (12 puis 2) lors des gravures des empilements 20 et 10.

Enfin, en figure 5, on finalise la définition du système multicouches par une délimitation de la première couche électriquement conductrice 2.

En résumé, dans l'exemple illustré, des dépôts pleine plaque suivies de lithographie, et de gravures de conceptions similaires peuvent suffire à la création de cette structure.

Cette structure est par ailleurs de configuration géométrique adaptée à une reprise de contact au niveau d'une projection latérale de chaque couche électriquement conductrice.

On configure en effet les masques 3, 4, 5 et 6, et donc le contour des couches 2, 12, 22 et 32 de sorte à préserver, pour chacune de ces couches 2, 12, 22, 32 une zone dont la surface n'est pas recouverte par le reste de la structure. Cette zone constitue une portion périphérique 8, 18, 28 des couches situées sous l'empilement 30 lui-même facilement accessible par sa surface supérieure 38.

Pour préserver les portions périphériques 8, 18, 28, on fait en sorte que, à chaque succession d'étages de lithographie et de gravure, en descendant vers la face du substrat, l'empilement 10, 20, 30 créé soit tel que sa superficie est inférieure à celle de l'empilement inférieur et que son contour soit contenu dans celui de l'empilement inférieur. Cette précaution est aussi prise pour le contour et la superficie de la première couche conductrice 2 relativement au premier empilement 10. Ainsi, on préserve une portion exposée périphérique 8, 18, 28 non recouverte.

A titre d'illustration, on a repéré 29 une zone de la couche 22 du deuxième empilement 20 qui est recouverte par le reste du dispositif. La zone 29 et la portion périphérique 28 se complémentent pour former l'intégralité de la couche 22.

La structure multicouches ainsi produite peut être de diverses formes. La vue de dessus de la figure 7 en présente un exemple. Elle révèle aussi le rétrécissement de section auquel sont soumises les couches conductrices 2, 12, 22, 32 qui se succèdent en alternance avec les couches isolantes 11, 21, 31. En figure 7, la portion périphérique 8 de la première couche 2 se présente sous forme d'une projection latérale suivant le plan de la face de substrat 1. Le contour du reste de la première couche 2 est ici sensiblement rectangulaire. Le contour de la couche 12, et du reste de l'empilement 10, est lui aussi sensiblement rectangulaire. Le contour de la couche 22, et du reste de l'empilement 20, s'inscrit à l'intérieur du contour précédent avec une partie en retrait suivant le plan de la face de substrat, pour laisser découverte la portion 18 de la couche 12.

Enfin, le contour de la couche 32, et du reste de l'empilement 30, s'inscrit dans celui de l'empilement 20, avec un retrait suivant le plan de la face du substrat 1 pour laisser découverte la portion 28 de la couche 22.

La portion exposée périphérique 8, 18, 28 non recouverte de chaque couche conductrice 2, 12, 22 intermédiaire est continue suivant le contour de la couche considérée. Ainsi, la portion périphérique forme-t-elle une surface fermée, en boucle, en périphérie de la couche.

Des définitions de contour, en particulier avec des gravures, sont mises en oeuvre par l'invention, de sorte à délimiter la forme des différentes couches. Les gravures, au niveau des flancs 13, 23, 33 peuvent créer des défauts pour le dispositif final, et produire des problèmes électriques ou/et des baisses de performance. Pour y remédier, la figure 6 illustre la formation de motifs servant à l'isolation électrique de la partie des couches conductrices 12, 22, 32 susceptibles d'être impactées par le défaut.

Plus précisément, la portion périphérique de chaque couche conductrice 12, 22, 32 des empilements 10, 20, 30 dispose d'un motif configuré pour distinguer une zone isolée 15, 25, 35 du reste de la couche conductrice 12, 22, 32. Le motif comporte une tranchée 14, 24, 34 réalisant évidement sur la totalité de l'épaisseur de la couche conductrice où elle est formée. Le motif isolant est une tranchée 14, 24, 34 à contour fermé formée dans l'intégralité de l'épaisseur de ladite couche électriquement conductrice 12, 22, 32. L'espace ainsi créé fait isolation électrique. Il peut en outre être ensuite rempli par un matériau diélectrique. Le motif d'isolation se situe dans la portion exposée périphérique (non recouverte) 18, 28, 38 de la couche conductrice 12, 22, 32. Pour la couche 32, la portion exposée 38 peut en pratique couvrir toute la surface de la couche 32, si cette couche n'est pas surmontée par une autre couche conductrice. Le motif suit par ailleurs l'ensemble du contour de la couche 12, 22, 32 où il est formé de sorte à séparer intégralement la zone isolée 15, 25, 35. La zone 15, 25, 35 forme la périphérie ou encore le contour extérieur de la couche conductrice considérée. Elle constitue une bordure à contour fermé, assimilable à un anneau, autour du reste de la couche conductrice 12, 22, 32.

La couche électriquement conductrice 12, 22, 32 de chaque empilement 10, 20, 30 comporte un motif électriquement isolant configuré pour définir une zone électriquement isolée périphérique 15, 25, 35 située dans la portion exposée 8, 18, 28, 38 de ladite couche électriquement conductrice 12, 22, 32.

La formation du motif isolant comprend la formation d'une tranchée 14, 24, 34 à contour fermé formée dans l'intégralité de l'épaisseur de ladite couche électriquement conductrice. La tranchée 14, 24, 34 des couches 12, 22, 32 peut être réalisée au cours d'une étape de gravure après la réalisation d'un masque 6 de définition des motifs de tranchée par photolithographie notamment. On peut utiliser le masque 6 de l'étape de gravure de la première couche 2 ou former deux masques successifs et graver successivement. La tranchée et la zone isolée peuvent avoir respectivement une largeur de 0,5 à 5µm.

Le résultat obtenu est une définition d'une partie active (c'est-à-dire efficace électriquement) dans les couches conductrices 12, 22, 32 en ayant éliminé une zone isolée 15, 25, 35 bordée par les flancs 13, 23, 33 des empilements. Dans le même temps, on préserve dans la portion exposée périphérique 8, 18, 28, 38 des couches conductrices une zone appartenant à la partie active de la couche et en même temps non recouverte, pour la reprise de contact.

Ces reprises de contact peuvent être produites après dépôt d'une couche isolante supérieure 9 et la création d'ouvertures dans cette couche 9 (par exemple par photolithographie et gravure), tel que visible en figure 8. Avantageusement, la couche 9 remplit aussi les tranchées 14, 24, 34.

Des éléments de reprise de contact 7, 17, 27, 37 peuvent ensuite être formés. Notamment on dépose sur la couche 9 et dans les ouvertures, un matériau conducteur, par exemple un métal de connexion tel que le titane, le nickel, l'or ou l'aluminium, avec une épaisseur indicative de 0.5 à 2 µm. Cette couche est ensuite gravée pour obtenir les éléments de reprise de contact 7, 17, 27, 37. Certains d'entre eux peuvent être reliés ou d'un seul bloc à partir de la couche de connexion déposée, pour former des interconnexions (par exemple celles repérées 16 et 26 en figure 10), entre les couches conductrices.

Ainsi la figure 10 montre une capacité par empilement MIM avec mise en connexion des électrodes correspondants aux couches 2 et 22 d'une part, et des électrodes correspondant aux couches 12 et 32 d'autre part.

Le procédé de l'invention permet donc les reprises de contact individuelles sur chacune des couches conductrices. Toute configuration électrique possible des capacités individuelles peut ainsi potentiellement être réalisée et en particulier la mise en parallèle de ces dernières afin d'obtenir le maximum de capacités pour une surface occupée donnée.

Outre les applications de routage décrites en introduction, les structures multicouches selon l'invention peuvent avantageusement être utilisées sous forme de capacités, notamment de forte densité, comme accumulateurs d'énergie ou éléments de filtrage dans de nombreux produits électroniques comme les alimentations électriques intégrées, les amplificateurs de signaux, les filtres de circuits radiofréquences (RF) et pour toutes sortes d'applications domestiques, ou par l'industrie automobile et celle des télécommunications où la miniaturisation amène des avantages de fiabilité et une réduction des coûts. Les dispositifs que l'on peut former peuvent s'inscrire dans des systèmes du type systèmes micro-électro-mécanique dits MEMS. Ce type de dispositifs peut se retrouver dans les produits de type domestique, automobile, télécommunication ou autre où la miniaturisation amène des avantages de fiabilité et de réduction de coûts.

La présente invention n'est pas limitée aux modes de réalisation précédemment décrits mais s'étend à tout mode de réalisation couvert par les revendications.

## Revendications

1. Dispositif électrique multicouches comprenant de manière successive en surface d'un substrat (1) :
- une première couche électriquement conductrice (2),
- une pluralité d'empilements (10, 20, 30) superposés au-dessus de la première couche électriquement conductrice (2), chaque empilement (10, 20, 30) comprenant une couche électriquement isolante (11, 21, 31) à laquelle est superposée une deuxième couche électriquement conductrice (12, 22, 32), chaque empilement (10, 20, 30) étant d'une superficie strictement plus petite que la couche électriquement conductrice (2, 12, 22) qui lui est immédiatement inférieure et chaque empilement (10, 20, 30) étant contenu dans le périmètre de ladite couche électriquement conductrice immédiatement inférieure de sorte à définir, dans chaque couche électriquement conductrice (2 ; 12, 22, 32), une portion exposée (8, 18, 28, 38) en périphérie de ladite couche électriquement conductrice (2 ; 12, 22, 32) et recouverte par aucun empilement (10, 20, 30), la portion exposée parcourant l'intégralité du contour de ladite couche électriquement conductrice (2 ; 12, 22, 32), dispositif dans lequel la couche électriquement conductrice (12, 22, 32) de chaque empilement (10, 20, 30) comporte un motif électriquement isolant s'étendant dans l'intégralité de l'épaisseur de la couche électriquement conductrice (12, 22, 32) sans s'étendre dans la couche électriquement isolante (11, 21, 31) sous-jacente, de sorte que la couche électriquement conductrice soit interrompue par le motif électriquement isolant, le motif isolant étant une tranchée (14, 24, 34) à contour fermé formée dans l'intégralité de l'épaisseur de ladite couche électriquement conductrice (12, 22, 32), le motif électriquement isolant étant configuré pour définir une zone électriquement isolée périphérique (15, 25, 35) située dans la portion exposée (8, 18, 28, 38) de ladite couche électriquement conductrice (12, 22, 32) comprenant un motif électriquement isolant, le dispositif comportant, pour la couche électriquement conductrice (12, 22, 32) de chaque empilement, un élément de reprise de contact (17, 27, 37) en continuité électrique avec une zone de connexion située dans la portion exposée (18, 28, 38) de ladite couche électriquement conductrice (12, 22, 32), hors de la zone électriquement isolée (15, 25, 35).

2. Dispositif selon la revendication précédente, dans lequel le contour de ladite couche électriquement conductrice (12, 22, 32) de chaque empilement (10, 20, 30) comprend une portion parallèle au contour de la couche électriquement conductrice immédiatement inférieure (2 ; 12, 22) et une portion en retrait relativement au contour de la couche électriquement conductrice immédiatement inférieure (2 ; 12, 22).

3. Dispositif selon la revendication précédente, comprenant un élément de reprise de contact (7) en continuité électrique avec une zone de connexion située dans la portion exposée (8) de la première couche électriquement conductrice (2), et dans lequel la zone de connexion de la couche électriquement conductrice immédiatement inférieure (2 ; 12, 22) à ladite couche électriquement conductrice (12, 22, 32) de chaque empilement (10, 20, 30) est située au niveau de la portion en retrait.

4. Dispositif selon l'une des revendications précédentes comportant une couche électriquement isolante (9) recouvrant l'intégralité des couches électriquement conductrices (2 ; 12, 22, 32) et traversée par les éléments de reprise de contact (7, 17, 27, 37).

5. Procédé de fabrication d'un dispositif électrique multicouches comprenant la formation, de manière successive en surface d'un substrat (1) :
- d'une première couche électriquement conductrice (2),
- d'une pluralité d'empilements (10, 20, 30) superposés au-dessus de la première couche électriquement conductrice (2), chaque empilement (10, 20, 30) comprenant une couche électriquement isolante (11, 21, 31) à laquelle est superposée une deuxième couche électriquement conductrice (12, 22, 32), chaque empilement (10, 20, 30) étant formé avec une superficie strictement plus petite que la couche électriquement conductrice (2 ; 12, 22) qui lui est immédiatement inférieure et chaque empilement (10, 20, 30) étant contenu dans le périmètre de ladite couche électriquement conductrice immédiatement inférieure de sorte à définir, dans chaque couche électriquement conductrice (2 ; 12, 22, 32), une portion exposée (8, 18, 28, 38) en périphérie de ladite couche électriquement conductrice (2 ; 12, 22, 32) et recouverte par aucun empilement (10, 20, 30), la portion exposée (8, 18, 28, 38) parcourant l'intégralité du contour de ladite couche électriquement conductrice (2 ; 12, 22, 32), procédé qui comprend la formation, dans la couche électriquement conductrice (12, 22, 32) de chaque empilement (10, 20, 30), d'un motif électriquement isolant s'étendant dans l'intégralité de l'épaisseur de la couche électriquement conductrice (12, 22, 32) sans s'étendre dans la couche électriquement isolante (11, 21, 31) sous-jacente, le motif isolant étant une tranchée (14, 24, 34) à contour fermé formée dans l'intégralité de l'épaisseur de ladite couche électriquement conductrice (12, 22, 32), le motif électriquement isolant étant configuré pour définir une zone électriquement isolée périphérique (15, 25, 35) située dans la portion exposée (18, 28, 38) de ladite couche électriquement conductrice (12, 22, 32) comprenant un motif électriquement isolant de sorte que la couche électriquement conductrice soit interrompue par le motif électriquement isolant, le procédé comportant en outre, pour la couche électriquement conductrice (12, 22, 32) de chaque empilement, la formation d'un élément de reprise de contact (17, 27, 37) en continuité électrique avec une zone de connexion située dans la portion exposée (18, 28, 38) de ladite couche électriquement conductrice (12, 22, 32), hors de la zone isolée (15, 25, 35).

6. Procédé selon la revendication précédente dans lequel ladite tranchée (14, 24, 34) dans ladite couche électriquement conductrice de chaque empilement est formée par masquage de définition d'un motif de tranchée suivi par une gravure d'une tranchée (14, 24, 34) en dehors du masque dans ladite couche électriquement conductrice (12, 22, 32) comprenant un motif isolant.

7. Procédé selon la revendication précédente dans lequel les tranchées (14, 24, 34) des couches électriquement conductrices (12, 22, 32) de chaque empilement (10, 20, 30) sont formées lors des mêmes étapes de masquage et de gravure.

8. Procédé selon l'une des revendications 4 à 7, dans lequel le contour de ladite couche électriquement conductrice (12, 22, 32) de chaque empilement (10, 20, 30) est formé avec une portion parallèle au contour de la couche électriquement conductrice immédiatement inférieure (2 ; 12, 22) et une portion en retrait relativement au contour de la couche électriquement conductrice (2 ; 12, 22) immédiatement inférieure.

9. Procédé selon la revendication précédente, dans lequel on forme un élément de reprise de contact (7) en continuité électrique avec une zone de connexion située dans la portion exposée (8) de la première couche électriquement conductrice (2), et dans lequel la zone de connexion de la couche électriquement conductrice immédiatement inférieure (2 ; 12, 22) à ladite couche électriquement conductrice (12, 22, 32) de chaque empilement (10, 20, 30) est réalisée de sorte à être située au niveau de la portion en retrait.

10. Procédé selon l'une des revendications 4 à 9, comportant la formation d'une couche électriquement isolante supérieure (9) recouvrant l'intégralité des couches électriquement conductrices (2 ; 12, 22, 32) et traversée par les éléments de reprise de contact (7, 17, 27, 37).

11. Procédé selon la revendication précédente dans lequel la formation d'un élément de reprise de contact (7, 17, 27, 37) est opérée par une gravure de motifs d'éléments de reprise de contact au travers de la couche électriquement isolante supérieure (9), un dépôt d'une couche d'un matériau électriquement conducteur au-dessus de la couche électriquement isolante supérieure et dans lesdits motifs, puis une gravure de la couche d'un matériau électriquement conducteur de sorte à définir les éléments de reprise de contact (7, 17, 27, 37).

12. Procédé selon la revendication précédente dans lequel la gravure de la couche d'un matériau électriquement conducteur est configurée pour isoler électriquement l'un de l'autre au moins deux éléments de reprise de contact.

13. Procédé selon l'une des revendications 4 à 12, dans lequel la formation de la première couche électriquement conductrice (2) et de la pluralité d'empilements (10, 20, 30) comprend :
- des dépôts pleine plaque successifs, à partir de la surface de substrat (1), d'une couche de formation de la première couche électriquement conductrice (2) et d'autant d'alternances de couches isolantes et de couches électriquement conductrices (12, 22, 32) que d'empilements (10, 20, 30),
- pour chaque empilement (10, 20, 30), en commençant par l'empilement (30) de plus haut niveau au-dessus de la surface du substrat (1), un masquage de définition d'un motif dudit empilement (10, 20, 30) et une gravure des couches de l'alternance correspondant audit empilement (10, 20, 30) en dehors du masque, ladite gravure étant configurée pour préserver l'empilement (10, 20) immédiatement inférieur audit empilement (20, 30) ou la couche de formation de la première couche électriquement conductrice (2),
- après la formation de tous les empilements (10, 20, 30), un masquage de définition d'un motif de la première couche électriquement conductrice (2) et une gravure de la couche de formation de la première couche électriquement conductrice (2) en dehors du masquage (3).

14. Procédé selon la revendication précédente en combinaison avec la revendication 7, dans lequel on opère le masquage de définition d'un motif de la première couche électriquement conductrice (2) et le masquage de définition des motifs de tranchée (14, 24, 34) lors d'une même étape, et la gravure de la couche de formation de la première couche électriquement conductrice (2) et la gravure des tranchées (14, 24, 34) lors d'une même étape.

## Patentansprüche

1. Elektrische Mehrschichtenvorrichtung, die nacheinander an der Oberfläche eines Substrats (1) Folgendes umfasst:
- eine erste elektrisch leitende Schicht (2),
- eine Vielzahl von Stapelungen (10, 20, 30), die über der ersten elektrisch leitenden Schicht (2) überlagert sind, wobei jede Stapelung (10, 20, 30) eine elektrisch isolierende Schicht (11, 21, 31) umfasst, der eine zweite elektrisch leitende Schicht (12, 22, 32) überlagert ist, wobei jede Stapelung (10, 20, 30) eine strikt kleinere Oberfläche aufweist als die elektrisch leitende Schicht (2, 12, 22), die unmittelbar unter ihr liegt, und jede Stapelung (10, 20, 30) in dem Bereich der elektrisch leitenden Schicht, die unmittelbar darunter liegt, derart enthalten ist, dass in jeder elektrisch leitenden Schicht (2; 12, 22, 32) ein exponierter Abschnitt (8, 18, 28, 38) am Umfang der elektrisch leitenden Schicht (2; 12, 22, 32) und der von keiner Stapelung (10, 20, 30) abgedeckt ist, enthalten ist, wobei der exponierte Abschnitt die gesamte Kultur der elektrisch leitenden Schicht (2; 12, 22, 32) durchläuft,
Vorrichtung, in der die elektrisch leitende Schicht (12, 22, 32) jeder Stapelung (10, 20, 30) eine elektrisch isolierende Struktur umfasst, die sich in der gesamten Dicke der elektrisch leitenden Schicht (12, 22, 32) erstreckt, ohne sich in der darunter liegenden elektrisch isolierenden Schicht (11, 21, 31) zu erstrecken, so dass die elektrisch leitende Schicht von der elektrisch isolierenden Struktur unterbrochen ist, wobei die isolierende Struktur ein Graben (14, 24, 34) mit geschlossener Kontur ist, der in der gesamten Dicke der elektrisch leitenden Schicht (12, 22, 32 gebildet ist,
wobei die elektrisch isolierende Struktur dazu konfiguriert ist, eine elektrisch isolierte Umfangszone (15, 25, 35) zu definieren, die in dem exponierten Abschnitt (8, 18, 28, 38) der elektrisch leitenden Schicht (12, 22, 32) liegt, der eine elektrisch isolierende Struktur umfasst, wobei die Vorrichtung für die elektrisch leitende Schicht (12, 22, 32) jeder Stapelung,
ein Kontakt-Wiederaufnahmeelement (17, 27, 37) in elektrischer Kontinuität mit einer Verbindungszone umfasst, die in dem exponierten Abschnitt (18, 28, 38) der elektrisch leitenden Schicht (12, 22, 32) außerhalb der elektrisch isolierten Zone (15, 25, 35) liegt.

2. Vorrichtung nach dem vorstehenden Anspruch, wobei die Kontur der elektrisch leitenden Schicht (12, 22, 32) jeder Stapelung (10, 20, 30) einen Abschnitt parallel zu der Kontur der unmittelbar darunter liegenden elektrisch leitenden Schicht (2; 12, 22) und einen Abschnitt im Rücksprung in Bezug auf die Kontur der unmittelbar darunter liegenden elektrisch leitenden Schicht (2; 12, 22) umfasst.

3. Vorrichtung nach dem vorstehenden Anspruch, die ein Kontakt-Wiederaufnahmeelement (7) in elektrische Kontinuität mit einer Verbindungszone umfasst, die in dem exponierten Abschnitt (8) der ersten elektrisch leitenden Schicht (2) liegt, und wobei die Verbindungszone der elektrisch leitenden Schicht (2; 12, 22), die unmittelbar unter der elektrisch leitenden Schicht (12, 22, 32) jeder Stapelung (10, 20, 30) liegt, in dem Bereich des Abschnitts im Rücksprung liegt.

4. Vorrichtung nach einem der vorstehenden Ansprüche, die eine elektrisch isolierende Schicht (9) umfasst, die sämtliche elektrisch leitenden Schichten (2; 12, 22, 32) abdeckt und von den Kontakt-Wiederaufnahmeelementen (7, 17, 27, 37) durchquert ist.

5. Verfahren zur Fertigung einer elektrischen Mehrschichtenvorrichtung, die das Bilden auf aufeinanderfolgende Art an der Oberfläche eines Substrats (1) von Folgendem umfasst:
- einer ersten elektrisch leitenden Schicht (2),
- einer Vielzahl von Stapelungen (10, 20, 30), die über der ersten elektrisch leitenden Schicht (2) überlagert sind, wobei jede Stapelung (10, 20, 30) eine elektrisch isolierende Schicht (11, 21, 31) umfasst, der eine zweite elektrisch leitende Schicht (12, 22, 32) überlagert ist, wobei jede Stapelung (10, 20, 30) mit einer strikt kleineren Oberfläche gebildet ist als die elektrisch leitende Schicht (2; 12, 22), die unmittelbar und ihr liegt, und jede Stapelung (10, 20, 30) in dem Bereich der elektrisch leitenden Schicht, die unmittelbar darunter liegt, derart enthalten ist, dass in jeder elektrisch leitenden Schicht (2; 12, 22, 32) ein exponierter Abschnitt (8, 18, 28, 38) am Umfang der elektrisch leitenden Schicht (2; 12, 22, 32) und der von einer Stapelung (10, 20, 30) abgedeckt ist, enthalten ist, wobei der exponierte Abschnitt (8, 18, 28, 38) die gesamte Kontur der elektrisch leitenden Schicht (2; 12, 22, 32) durchläuft,
Verfahren, das die Bildung in der elektrisch leitenden Schicht (12, 22, 32) jeder Stapelung (10, 20, 30) einer elektrisch isolierenden Struktur umfasst, die sich in der gesamten Dicke der elektrisch leitenden Schicht (12, 22, 32) erstreckt, ohne sich in der darunter liegenden elektrisch isolierenden Schicht (11, 21, 31) zu erstrecken, wobei die isolierende Struktur ein Graben (14, 24, 34) mit geschlossener Kontur in der gesamten Dicke der elektrisch leitenden Schicht (12, 22, 32) ist, wobei die elektrisch isolierende Struktur dazu konfiguriert ist, eine elektrisch isolierte Umfangszone (15, 25, 35) zu definieren, die in dem exponierten Abschnitt (18, 28, 38) der elektrisch leitenden Schicht (12, 22, 32) liegt, der eine elektrisch isolierende Struktur derart umfasst, dass die elektrisch leitende Struktur von der elektrisch isolierenden Struktur unterbrochen ist, wobei das Verfahren außerdem für die elektrisch leitende Schicht (12, 22, 32) jeder Stapelung die Bildung eines Kontakt-Wiederaufnahmeelements (17, 27, 37) in elektrischer Kontinuität mit einer Verbindungszone umfasst, die in dem exponierten Abschnitt (18, 28, 38) der elektrisch leitenden Schicht (12, 22, 32) außerhalb der isolierten Zone (15, 25, 35) liegt.

6. Verfahren nach dem vorstehenden Anspruch, wobei der Graben (14, 24, 34) in der elektrisch leitenden Schicht jeder Stapelung durch Definitionsmaskierung einer Grabenstruktur gefolgt von einer Ätzung eines Grabens (14, 24, 34) außerhalb der Maske in der elektrisch leitenden Schicht (12, 22, 32), die eine isolierende Struktur umfasst, gebildet wird.

7. Verfahren nach dem vorstehenden Anspruch, wobei die Gräben (14, 24, 34) der elektrisch leitenden Schichten (12, 22, 32) jeder Stapelung (10, 20, 30) bei denselben Maskierungs- und Ätzschritten gebildet werden.

8. Verfahren nach einem der Ansprüche 4 bis 7, wobei die Kontur der elektrisch leitenden Schicht (12, 22, 32) jeder Stapelung (10, 20, 30) mit einem Abschnitt parallel zu der Kontur der unmittelbar darunter liegenden elektrisch leitenden Schicht (2; 12, 22) und einem Abschnitt im Rücksprung in Bezug auf die Kontur der unmittelbar darunter liegenden elektrisch leitenden Schicht (2; 12, 22) gebildet ist.

9. Verfahren nach dem vorstehenden Anspruch, wobei ein Kontakt-Wiederaufnahmeelement (7) in elektrischer Kontinuität mit einer Verbindungszone, die in dem exponierten Abschnitt (8) der ersten elektrisch leitenden Schicht (2) liegt, gebildet wird, und wobei Verbindungszone der elektrisch leitenden Schicht (2; 12, 22), die unmittelbar unter der elektrisch leitenden Schicht (12, 22, 32) jeder Stapelung (10, 20, 30) liegt, derart gebildet ist, dass sie im Bereich des Abschnitts im Rücksprung liegt.

10. Verfahren nach einem der Ansprüche 4 bis 9, das die Bildung einer oberen elektrisch leitenden Schicht (9) umfasst, die sämtliche elektrisch leitenden Schichten (2; 12, 22, 32) abdeckt und von den Kontakt-Wiederaufnahmeelementen (7, 17, 27, 37) durchquert ist.

11. Verfahren nach dem vorstehenden Anspruch, wobei die Bildung eines Kontakt-Wiederaufnahmeelements (7, 17, 27, 37) durch eine Ätzung von Kontakt-Wiederaufnahmestrukturen durch die obere elektrisch isolierende Schicht (9), eine Ablagerung einer Schicht aus einem elektrisch leitenden Material oberhalb der oberen elektrisch isolierenden Schicht und in den Strukturen, dann eine Ätzung der Schicht aus einem elektrisch leitenden Material derart erfolgt, dass die Kontakt-Wiederaufnahmeelemente (7, 17, 27, 37) definiert werden.

12. Verfahren nach dem vorstehenden Anspruch, wobei die Ätzung der Schicht aus einem elektrisch leitenden Material dazu konfiguriert ist, mindestens zwei Kontakt-Wiederaufnahmeelemente voneinander elektrisch zu isolieren.

13. Verfahren nach einem der Ansprüche 4 bis 12, wobei die Bildung der ersten elektrisch leitenden Schicht (2) und der Vielzahl von Stapelungen (10, 20, 30) Folgendes umfasst:
- aufeinanderfolgende Vollplattenabscheidungen ausgehend von der Oberfläche des Substrats (1) einer Schicht zur Bildung der ersten elektrisch leitenden Schicht (2) und ebenso viele Wechsel isolierender Schichten und elektrisch leitender Schichten (12, 22, 32) wie Stapelungen (10, 20, 30),
- für jede Stapelung (10, 20, 30), ausgehend von der Stapelung (30) an dem höchsten Niveau oberhalb der Oberfläche des Substrats (1) einer Definitionsmaskierung einer Struktur der Stapelung (10, 20, 30) und einer Ätzung der abwechselnden Schichten, die der Stapelung (10, 20, 30) entsprechen, außerhalb der Maske, wobei die Ätzung dazu konfiguriert ist, die Stapelung (10) unmittelbar unter der Stapelung (20, 30) oder der Schicht zur Bildung der ersten elektrisch leitenden Schicht (2) nach der Bildung einer Stapelung (10, 20, 30), einer Definitionsmaskierung der ersten elektrisch leitenden Schicht (2) und einer Ätzung der Schicht zur Bildung der ersten elektrisch leitenden Schicht (2) außerhalb der Maskierung (3) zu bewahren.

14. Verfahren nach dem vorstehenden Anspruch, kombiniert mit Anspruch 7, wobei die Definitionsmaskierung einer Struktur der ersten elektrisch leitenden Schicht (2) und die Definitionsmaskierung der Grabenstrukturen (14, 24, 34) bei demselben Schritt, und die Ätzung der Schicht zur Bildung der ersten elektrisch leitenden Schicht (2) und der Ätzung der Gräben (14, 24, 34) bei demselben Schritt erfolgen.

## Claims

1. Multilayer electrical device successively comprising, on the surface of a substrate (1):
- a first electrically conductive layer (2),
- a plurality of stacks (10, 20, 30) superposed above the first electrically conductive layer (2), each stack (10, 20, 30) comprising an electrically insulating layer (11, 21, 31) to which is superposed a second electrically conductive layer (12, 22, 32), each stack (10, 20, 30) being of a surface area strictly smaller than the electrically conductive layer (2, 12, 22) which itself is immediately lower, and each stack (10, 20, 30) being contained in the perimeter of said immediately lower electrically conductive layer so as to define, in each electrically conductive layer (2; 12, 22, 32), an exposed portion (8, 18, 28, 38) at the periphery of said electrically conductive layer (2; 12, 22, 32) and covered by any stack (10, 20, 30), the exposed portion travelling all of the contour of said electrically conductive layer (2; 12, 22, 32), device wherein the electrically conductive layer (12, 22, 32) of each stack (10, 20, 30) comprises an electrically insulating pattern extending through the entire thickness of the electrically conductive layer (12, 22, 32) without extending into the underlying electrically insulating layer (11, 21, 31), such that the electrically conductive layer is interrupted by the electrically insulating pattern, the insulating pattern being a trench (14, 24, 34) at the closed contour formed through the entire thickness of said electrically conductive layer (12, 22, 32), the electrically insulating pattern being configured to define a peripheral electrically insulating zone (15, 25, 35) located in the exposed portion (8, 18, 28, 38) of said electrically conductive layer (12, 22, 32) comprising an electrically insulating pattern, the device comprising, for the electrically conductive layer (12, 22, 32) of each stack, a reconnection element (17, 27, 37) in electrical continuation with a connection zone located in the exposed portion (18, 28, 38) of said electrically conductive layer (12, 22, 32), outside of the electrically insulated zone (15, 25, 35).

2. Device according to the preceding claim, wherein the contour of said electrically conductive layer (12, 22, 32) of each stack (10, 20, 30) comprises a portion parallel to the contour of the immediately lower electrically conductive layer (2; 12, 22) and a portion set back relative to the contour of the immediately lower electrically conductive layer (2; 12, 22).

3. Device according to the preceding claim, comprising a reconnection element (7) in electrical continuation with a connection zone located in the exposed portion (8) of the first electrically conductive layer (2), and wherein the connection zone of the immediately lower electrically conductive layer (2; 12, 22) to said electrically conductive layer (12, 22, 32) of each stack (10, 20, 30) is located at the set-back portion.

4. Device according to one of the preceding claims comprising an electrically insulating layer (9) covering all of the electrically conductive layers (2; 12, 22, 32) and passed through by the reconnection elements (7, 17, 27, 37).

5. Method for manufacturing a multilayer electrical device comprising the formation, successively on the surface of a substrate (1):
- a first electrically conductive layer (2),
- a plurality of stacks (10, 20, 30) superposed above the first electrically conductive layer (2), each stack (10, 20, 30) comprising an electrically insulating layer (11, 21, 31) to which is superposed a second electrically conductive layer (12, 22, 32), each stack (10, 20, 30) being formed with a surface area strictly smaller than the electrically conductive layer (2, 12, 22), which itself is immediately lower and each stack (10, 20, 30) being contained in the perimeter of said immediately lower electrically conductive layer so as to define, in each electrically conductive layer (2; 12, 22, 32), an exposed portion (8, 18, 28, 38) at the periphery of said electrically conductive layer (2; 12, 22, 32) and covered by any stack (10, 20, 30), the exposed portion travelling all of the contour of said electrically conductive layer (2; 12, 22, 32), method which comprises the formation, in the electrically conductive layer (12, 22, 32) of each stack (10, 20, 30), of an electrically insulating pattern extending through the entire thickness of the electrically conductive layer (12, 22, 32) without extending into the underlying electrically insulating layer (11, 21, 31), the insulating pattern being a trench (14, 24, 34) at the closed contour formed through the entire thickness of said electrically conductive layer (12, 22, 32), the electrically insulating pattern configured to define a peripheral electrically insulated zone (15, 25, 35) located in the exposed portion (18, 28, 38) of said electrically conductive zone (12, 22, 32) comprising an electrically insulating pattern, such that the electrically conductive layer is interrupted by the electrically insulating pattern, the method further comprising, for the electrically conductive layer (12, 22, 32) of each stack, the formation of a reconnection element (17, 27, 37) in electrical continuation with a connection zone located in the exposed portion (18, 28, 38) of said electrically conductive layer (12, 22, 32), outside of the insulated zone (15, 25, 35).

6. Method according to the preceding claim, wherein said trench (14, 24, 34) in said electrically conductive layer of each stack is formed by definition masking of a trench pattern followed by an etching of a trench (14, 24, 34) outside of the mask in said electrically conductive layer (12, 22, 32) comprising an insulating pattern.

7. Method according to the preceding claim, wherein the trenches (14, 24, 34) of the electrically conductive layers (12, 22, 32) of each stack (10, 20, 30) are formed during the same masking and etching steps.

8. Method according to one of claims 4 to 7, wherein the contour of said electrically conductive layer (12, 22, 32) of each stack (10, 20, 30) is formed with a portion parallel to the contour of the immediately lower electrically conductive layer (2; 12, 22) and a portion set back relative to the contour of the immediately lower electrically conductive layer (2; 12, 22).

9. Method according to the preceding claim, wherein a reconnection element (7) is formed in electrical continuation with a connection zone located in the exposed portion (8) of the first electrically conductive layer (2), and wherein the connection zone of the immediately lower electrically conductive layer (2; 12, 22) at said electrically conductive layer (12, 22, 32) of each stack (10, 20, 30) is made so as to be located at the set-back portion.

10. Method according to one of claims 4 to 9, comprising the formation of an upper electrically insulating layer (9) covering all of the electrically conductive layers (2; 12, 22, 32) and passed through by the reconnection elements (7, 17, 27, 37).

11. Method according to the preceding claim, wherein the formation of a reconnection element (7, 17, 27, 37) is performed by an etching of reconnection element patterns through the upper electrically insulating layer (9), a deposition of a layer of an electrically conductive material above the upper electrically insulating layer and in said patterns, then an etching of the layer of an electrically conductive material, so as to define the reconnection elements (7, 17, 27, 37).

12. Method according to the preceding claim, wherein the etching of the layer of an electrically conductive layer is configured to electrically insulate at least either of the two reconnection elements.

13. Method according to one of claims 4 to 12, wherein the formation of the first electrically conductive layer (2) and of the plurality of stacks (10, 20, 30) comprises:
- successive full-wafer depositions, from the substrate surface (1), of a formation layer of the first electrically conductive layer (2) and as many alternances of insulating layers and of electrically conductive layers (12, 22, 32) as stacks (10, 20, 30),
- for each stack (10, 20, 30), starting with the stack (30) of a higher level above the surface of the substrate (1), a definition masking of a pattern of said stack (10, 20, 30) and an etching of the layers of the corresponding alternance to said stack (10, 20, 30) outside of the mask, said etching being configured to preserve the stack (10) immediately lower to said stack (20, 30) or the formation layer of the first electrically conductive layer (2),
- after the formation of all the stacks (10, 20, 30), a definition masking of a pattern of the first electrically conductive layer (2) and an etching of the formation layer of the first electrically conductive layer (2) outside of the masking (3).

14. Method according to the preceding claim, combined with claim 7, wherein the definition masking of a pattern of the first electrically conductive layer (2) and the definition masking of the trench patterns (14, 24, 34) are performed during one same step, and the etching of the formation layer of the first electrically conductive layer (2) and the etching of the trenches (14, 24, 34) during one same step.
